# EUROPEAN PATENT APPLICATION

(11) **EP 4 597 820 A1**
(43) Date of publication of application: **06.08.2025**
(21) Application number: 25150951.9
(22) Date of filing: 09.01.2025
(51) Int. Cl.: H02M 7/5387, H02M 7/00, H02K 11/33, H02K 9/19, H05K 7/20

(54) **POWER CONVERSION DEVICE**

(30) Priority: 31.01.2024 JP 2024013315; 08.11.2024 JP 2024196072
(71) Applicant: AISIN CORPORATION, Kariya, Aichi 448-8650 (JP)
(72) Inventor: SATO, Ryota, Kariya, 448-8650 (JP)
(74) Representative: Kramer Barske Schmidtchen Patentanwälte PartG mbB

(57) **Abstract**

A power conversion device (B) includes: a plurality of electronic components (66a, 70a); and a cooling plate (11, 12) configured to allow a coolant for cooling the plurality of electronic components to flow therein. The plurality of electronic components include at least a first cooling target and a second cooling target. The cooling plate includes a first flow path (11C) formed in a horizontal direction and configured to cool the first cooling target, and a second flow path (11D) disposed downstream of the first flow path and configured to cool the second cooling target. The second flow path includes a bubble reservoir (80) positioned above the first flow path and configured to store a bubble while causing the coolant to flow.

## Description

### TECHNICAL FIELD

This disclosure relates to a power conversion device.

### BACKGROUND DISCUSSION

In recent years, automobiles including a motor as a traveling drive source (such as a hybrid electric vehicle (HEV), a plug-in hybrid electric vehicle (PHEV), a battery electric vehicle (BEV), and a fuel cell electric vehicle (FCEV)) have become widespread. These automobiles are provided with a vehicle drive device that drives a motor or the like, and the vehicle drive device is provided with a power conversion device including a plurality of electronic components.

JP 2011-217553A (Reference 1) cited below discloses a power conversion device. The power conversion device includes a semiconductor module constituting a power conversion circuit and a cooling case that cools the semiconductor module with a refrigerant, and is configured to be capable of cooling the semiconductor module disposed on an upper wall surface of the cooling case with the refrigerant.

As in the power conversion device described in Reference 1, bubbles may flow into a flow path formed inside the cooling case together with the refrigerant. The bubbles may stay below an upper wall surface of the flow path facing the semiconductor module, and in this case, cooling efficiency for the semiconductor module is reduced. Therefore, in the power conversion device described in Reference 1, a refrigerant inlet pipe and a refrigerant outlet pipe connected to the cooling case are positioned above the upper wall surface of the cooling case. In this manner, the bubbles can be less likely to stay in the cooling case.

However, in the power conversion device described in Reference 1, when a flow speed of the refrigerant is low, there is still a possibility that the bubbles stay on the upper wall surface of the cooling case, and there is room for improvement.

A need thus exists for a power conversion device in which bubbles mixed in a coolant are less likely to stay in a portion of a cooling flow path facing an electronic component even when a flow speed of the coolant is low.

### SUMMARY

A power conversion device according to one aspect of this disclosure includes: a plurality of electronic components; and a cooling plate configured to allow a coolant for cooling the plurality of electronic components to flow therein, in which the plurality of electronic components include at least a first cooling target and a second cooling target, the cooling plate includes a first flow path formed in a horizontal direction and configured to cool the first cooling target, and a second flow path disposed downstream of the first flow path and configured to cool the second cooling target, and the second flow path includes a bubble reservoir positioned above the first flow path and configured to store a bubble while causing the coolant to flow.

According to this configuration, when the coolant cools the first cooling target and the second cooling target in this order, even if bubbles are mixed in the coolant, the bubbles can stay in the bubble reservoir positioned above the first flow path that cools the first cooling target. Accordingly, for example, by disposing the first cooling target at a position other than a position facing the bubble reservoir, the first cooling target and the second cooling target can be reliably cooled by the coolant flowing through the cooling plate. In addition, since the bubble reservoir can store the bubbles while causing the coolant to flow, even if the bubbles continue to stay in the bubble reservoir due to a low flow speed of the coolant, the flow of the coolant is not hindered. In this manner, a power conversion device capable of effectively cooling the plurality of electronic components can be implemented.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a longitudinal cross-sectional view of a vehicle drive device accommodating a conversion module;
FIG. 2 is a perspective view of a power conversion device;
FIG. 3 is a cooling circuit diagram showing a cooling fluid flow path and a refrigerant flow path;
FIG. 4 is a cross-sectional view taken along a line IV-IV in FIG. 1;
FIG. 5 is a cross-sectional view taken along a line V-V in FIG. 1;
FIG. 6 is a partial cross-sectional view of a cooling plate according to a first embodiment;
FIG. 7 is a partial cross-sectional view of a cooling plate according to a comparative example;
FIG. 8 is a partial cross-sectional view of a cooling plate according to a modification; and
FIG. 9 is a partial cross-sectional view of a cooling plate according to a second embodiment.

### DETAILED DESCRIPTION

Hereinafter, a cooling flow path structure according to embodiments disclosed here will be described with reference to the drawings. In the present embodiment, the cooling flow path structure cools a plurality of electronic components disposed in a power conversion device B, but is not limited to the following embodiments, and various modifications can be made without departing from the gist thereof.

### Basic Configuration

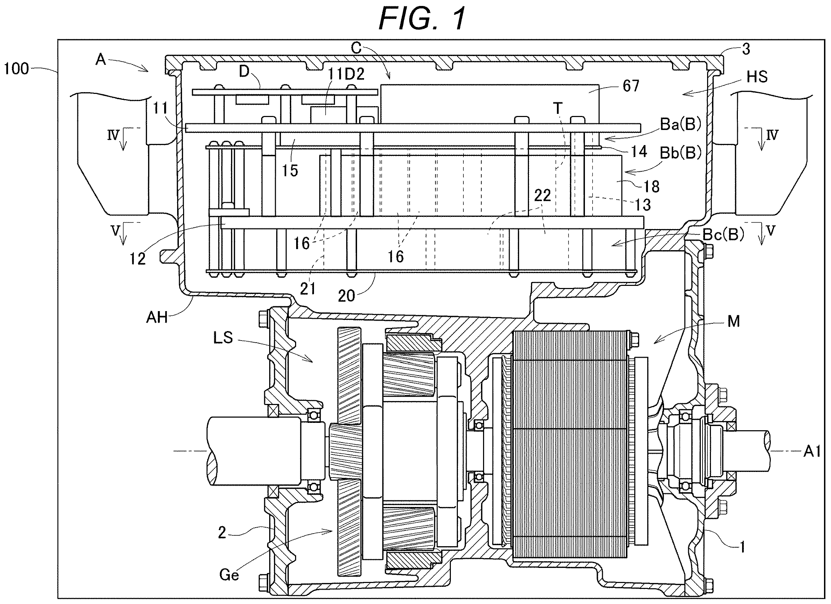

FIG. 1 shows a vehicle drive device A that transmits a drive force from a traveling motor M to driving wheels (not shown) of a vehicle. The vehicle drive device A accommodates, in a housing AH, the traveling motor M, a gear mechanism Ge that reduces the drive force from the traveling motor M and that transmits the drive force to the driving wheels, the power conversion device B, and an inverter C. Hereinafter, the vehicle including the traveling motor M as a traveling drive source is also referred to as an electric vehicle. Examples of the electric vehicle include a hybrid electric vehicle (HEV), a plug-in hybrid electric vehicle (PHEV), a battery electric vehicle (BEV), and a fuel cell electric vehicle (FCEV).

Since the vehicle drive device A is provided in an upper-lower relationship shown in FIG. 1 in an electric vehicle 100, the upper-lower relationship will be described in the present embodiment in accordance with an upper-lower direction shown in FIG. 1. FIG. 1 shows a longitudinal section of the vehicle drive device A as viewed in a front-rear direction, and a left-right direction in FIG. 1 is a width direction of a vehicle body.

The power conversion device B converts AC power from an AC power supply (basically, a commercial power supply) supplied from an outside of the electric vehicle 100 into high-voltage DC power. The high-voltage DC power obtained by conversion is charged to a main battery (not shown) disposed outside the vehicle drive device A. The power conversion device B can convert the DC power from the main battery to generate AC power similar to that of the commercial power supply and supply the AC power to the outside of the electric vehicle 100.

The inverter C converts the DC power from the main battery into three-phase AC power, controls a frequency, and supplies the three-phase AC power to the traveling motor M. Accordingly, the driving wheels of the electric vehicle 100 are driven to cause the electric vehicle 100 to travel.

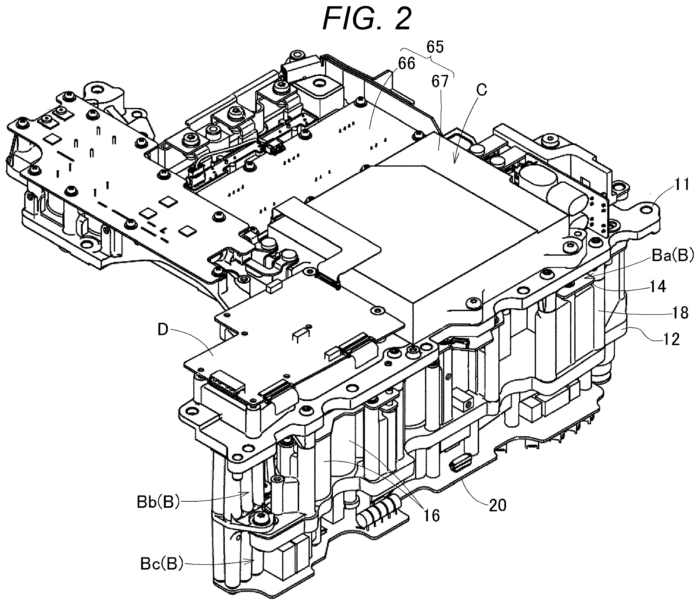

As shown in FIGS. 1 and 2, the power conversion device B includes a plurality of layers in which a plurality of conversion modules (a first conversion module Ba, a second conversion module Bb, and a third conversion module Bc) are disposed to overlap one another in the upper-lower direction. The inverter C is provided above the power conversion device B.

### Vehicle Drive Device

As shown in FIG. 1, the vehicle drive device A accommodates the traveling motor M and the gear mechanism Ge in a lower space LS of the housing AH. In the vehicle drive device A, an outer portion of the traveling motor M in the lower space LS is closed by a motor cover 1, and an outer portion of the gear mechanism Ge in the lower space LS is closed by a gear cover 2. A rotation axis A1 of the traveling motor M is coaxial with a rotation axis of the gear mechanism Ge.

The vehicle drive device A accommodates the power conversion device B and the inverter C in an upper space HS of the housing AH. The upper space HS is closed by an upper cover 3. The lower space LS and the upper space HS are independent spaces that do not communicate with each other.

As shown in FIG. 1, the power conversion device B includes a plurality of layers in which the plurality of conversion modules (the first conversion module Ba, the second conversion module Bb, and the third conversion module Bc) are disposed in a stacked state, and the inverter C is provided on an upper surface of the power conversion device B.

In the present embodiment, as described above, the power conversion device B and the inverter C are accommodated in the housing AH of the vehicle drive device A in an integrated state, but the power conversion device B may be configured to be separated from the inverter C. Further, the vehicle drive device A is configured to accommodate both the power conversion device B and the inverter C inside, but at least one of the power conversion device B and the inverter C may be disposed on an outer wall surface of the housing AH of the vehicle drive device A or outside the vehicle drive device A.

### Layer Structure of Power Conversion Device

As shown in FIGS. 1 and 2, in the power conversion device B, the first conversion module Ba, the second conversion module Bb, and the third conversion module Bc are disposed in this order from top to bottom. In the power conversion device B, a first cooling plate 11 (an example of a cooling plate) is disposed in an upper stage, a second cooling plate 12 (an example of the cooling plate) is disposed below the first cooling plate 11 at a set interval, and the first cooling plate 11 and the second cooling plate 12 are maintained at the set interval by connecting the first cooling plate 11 and the second cooling plate 12 via a spacer or the like.

As a specific disposition, in the power conversion device B, the first conversion module Ba and the second conversion module Bb are disposed below the first cooling plate 11 and above the second cooling plate 12, and the third conversion module Bc is disposed below the second cooling plate 12. Further, the inverter C is disposed above the first cooling plate 11.

The first conversion module Ba includes a plurality of switching elements 15 (an example of electronic components) mounted on an upper surface of a plate-shaped upper substrate 14. The upper substrate 14 is supported by the first cooling plate 11 in a state of being separated downward from the first cooling plate 11. The plurality of switching elements 15 constitute a part of an on board charger (OBC) unit.

FIG. 1 shows the plurality of switching elements 15 as one block. These plurality of switching elements 15 are disposed in contact with or close to a lower surface of the first cooling plate 11.

As shown in FIG. 1, the second conversion module Bb includes a transformer T mounted on a lower surface of the upper substrate 14, a plurality of bulk capacitors 16, and a frame member 18. The frame member 18 functions as a spacer by protruding downward from the lower surface of the upper substrate 14 in a state of surrounding at least a part of an outer periphery of the transformer T.

As shown in FIG. 1, the third conversion module Bc includes a plurality of coil modules 21 and a plurality of AC filters 22 on an upper surface of a lower substrate 20 that is disposed to be separated downward from a lower surface side of the second cooling plate 12.

Upper surfaces of the plurality of coil modules 21 and upper surfaces of the plurality of AC filters 22 are disposed in contact with or close to a lower surface of the second cooling plate 12.

### Cooling Circuit

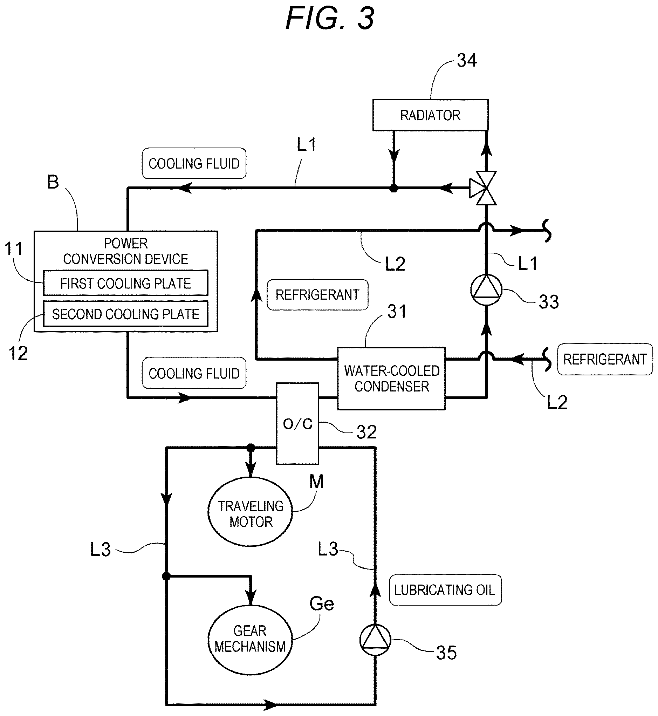

As shown in FIG. 3, the vehicle drive device A includes a cooling circuit including a coolant flow path L1 causing a coolant as a cooling fluid to circulate, a refrigerant flow path L2 causing a refrigerant to circulate, and a lubricating oil flow path L3 causing a lubricating oil to circulate. The cooling fluid in the present embodiment includes a long-life coolant (LLC) containing ethylene glycol, propylene glycol, or the like, and a coolant such as an insulating oil (hereinafter, referred to as a "coolant").

The coolant flow path L1 causes the coolant to circulate in an order of the first cooling plate 11 and the second cooling plate 12 of the power conversion device B, an oil cooler 32, a water-cooled condenser 31, and a radiator 34 by driving a coolant pump 33. A flow path R described later is a part of the coolant flow path L1.

The refrigerant flow path L2 is configured to supply the refrigerant cooled outside to the water-cooled condenser 31. In the refrigerant flow path L2, a hydrofluorocarbon (HFC), a hydrofluoroolefin (HFO), or the like is used as the refrigerant.

The lubricating oil flow path L3 supplies a low-temperature lubricating oil to an inside of the traveling motor M and to the gear mechanism Ge by driving a hydraulic pump 35.

In this cooling circuit, the coolant cooled by the radiator 34 flows through the flow path R in the first cooling plate 11 and the flow path R in the second cooling plate 12 of the power conversion device B. Accordingly, the coolant absorbs heat generated in the first conversion module Ba, the second conversion module Bb, and the third conversion module Bc, and cools the first conversion module Ba, the second conversion module Bb, and the third conversion module Bc. As a result, a temperature of the coolant increases.

The oil cooler 32 is disposed downstream of the power conversion device B in the coolant flow path L1, and performs heat exchange between the coolant circulating in the coolant flow path L1 and the oil. Accordingly, the temperature of the coolant further increases, and a temperature of the oil lowers. In this manner, the oil of which the temperature lowers is caused to flow through the lubricating oil flow path L3. Accordingly, an increase in temperatures of the traveling motor M and the gear mechanism Ge in the lower space LS of the housing AH is prevented, and the traveling motor M and the gear mechanism Ge are lubricated. The coolant of which the temperature increases in the oil cooler 32 absorbs heat from the refrigerant in the water-cooled condenser 31, is then lowered in temperature by heat radiation in the radiator 34, and is supplied to the power conversion device B again.

### Cooling Mechanism

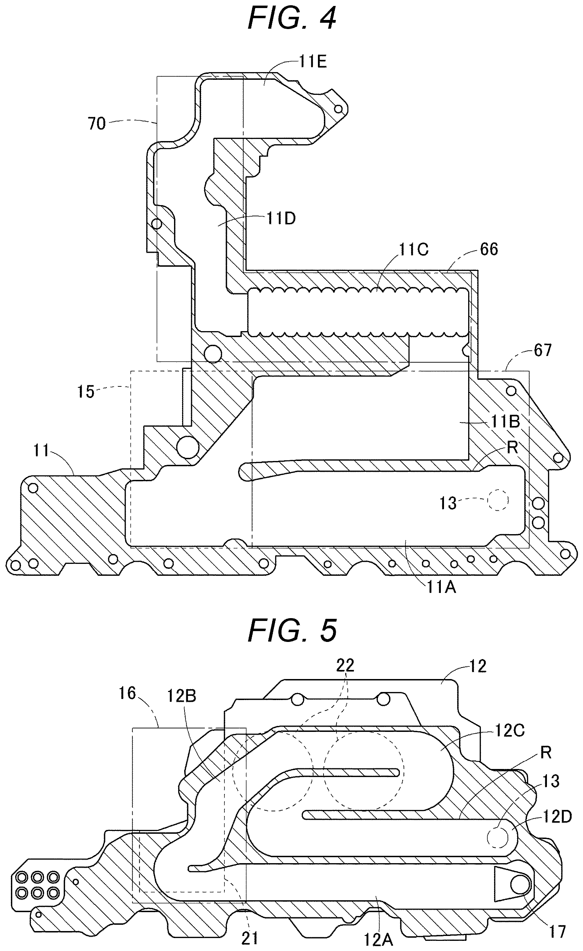

The power conversion device B is cooled by the coolant flowing through the first cooling plate 11 and the second cooling plate 12. As shown in FIGS. 4 and 5, the first cooling plate 11 and the second cooling plate 12 are configured such that the flow path R is continuous by a communication path 13 extending in the upper-lower direction between the first cooling plate 11 and the second cooling plate 12.

The coolant cooled by the radiator 34 or the like and reaching the power conversion device B flows into the flow path R in the second cooling plate 12 through an inlet port 17 of the second cooling plate 12 shown in FIG. 5. In the second cooling plate 12, a first portion 12A, a second portion 12B, a third portion 12C, and a fourth portion 12D are continuously formed. The flow path R is formed such that the coolant flows through the first portion 12A, the second portion 12B, the third portion 12C, and the fourth portion 12D in this order. The first portion 12A extends in a longitudinal direction of the lower substrate 20 (see FIG. 1, the same applies hereinafter). The second portion 12B is folded back to be curved and extend from an end portion of the first portion 12A. The third portion 12C is folded back from an end portion of the second portion 12B to extend in the longitudinal direction of the lower substrate 20. The fourth portion 12D is folded back from an end portion of the third portion 12C to extend in the longitudinal direction of the lower substrate 20. An end portion of the fourth portion 12D is connected to an end portion of the communication path 13.

The coolant flowing through the flow path R formed in the communication path 13 reaches the first cooling plate 11. As shown in FIG. 4, in the first cooling plate 11, a first portion 11A, a second portion 11B, a third portion 11C (an example of a first flow path), a fourth portion 11D (an example of a second flow path), and a fifth portion 11E are continuously formed. The flow path R is formed such that the coolant flows through the first portion 11A, the second portion 11B, the third portion 11C, the fourth portion 11D, and the fifth portion 11E in this order. The first portion 11A extends in the longitudinal direction of the lower substrate 20. The second portion 11B is folded back from an end portion of the first portion 11A and extends in the longitudinal direction of the lower substrate 20. The third portion 11C is folded back from an end portion of the second portion 11B and extends in the longitudinal direction of the lower substrate 20. The fourth portion 11D is folded back at a right angle from an end portion of the third portion 11C and extends in the longitudinal direction of the lower substrate 20. The fifth portion 11E is folded back from an end portion of the fourth portion 11D and extends in the longitudinal direction of the lower substrate 20. An outlet port (not shown) is formed at a downstream end portion of the fifth portion 11E, through which the coolant flows out of the power conversion device B.

Here, a heat generation amount and a heat resistant temperature (heat resistance) of each electronic component are compared as follows. That is, the conversion modules Ba, Bb, and Bc (power supply modules) each have a current value of, for example, 50 A or less. As compared with other electronic components, the bulk capacitors 16 have a relatively small heat generation amount and a relatively low heat resistant temperature, and the switching elements 15 of the conversion modules Ba, Bb, and Bc have a relatively small heat generation amount and a relatively high heat resistant temperature.

A main inverter unit 65 (inverter) has a current of, for example, 700A or less. As compared with other electronic components, a smoothing capacitor 67 has a relatively large heat generation amount and a relatively low heat resistant temperature, and a switching element 66a (an example of the electronic component, a first cooling target) of a motor drive circuit 66 has a relatively large heat generation amount and a relatively high heat resistant temperature.

A converter 70 has a current of, for example, 20 A or less, and a switching element 70a (an example of the electronic component, a second cooling target) of the converter 70 has a relatively small heat generation amount and a relatively high heat resistant temperature as compared with other electronic components. The traveling motor M (in particular, a stator) has a current of, for example, 700 A or less, and has a relatively large heat generation amount and a relatively high heat resistant temperature as compared with other electronic components.

In the present embodiment, the bulk capacitors 16 are disposed at positions corresponding to the first portion 12A and the second portion 12B of the second cooling plate 12 (see FIG. 5), and the switching elements 15 of the power supply modules are disposed at positions corresponding to the first portion 11A and the second portion 11B of the first cooling plate 11 (see FIG. 4).

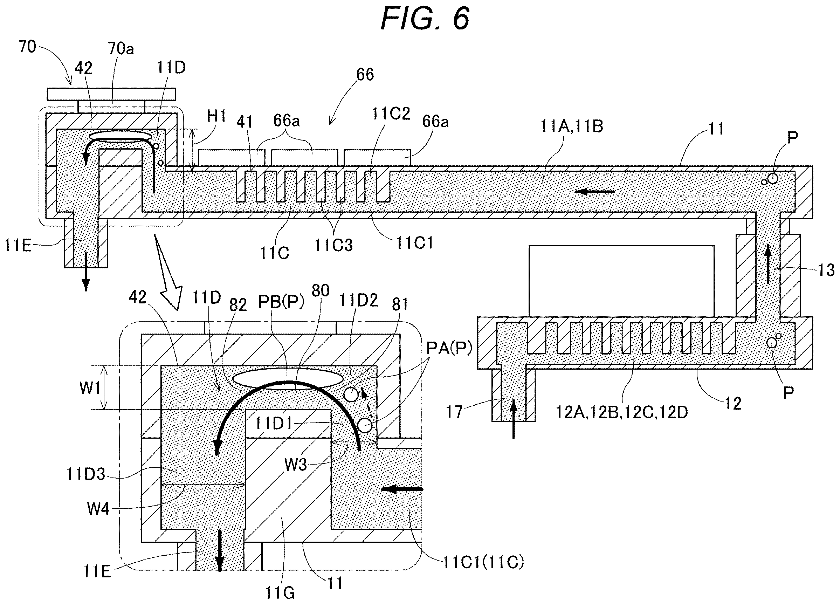

In the main inverter unit 65, the smoothing capacitor 67 is disposed at a position corresponding to the second portion 11B of the first cooling plate 11, and the switching elements 66a of the motor drive circuit 66 are disposed at a position corresponding to the third portion 11C of the first cooling plate 11 (see FIG. 6). As shown in FIG. 6, the third portion 11C includes a first path 11C1 and a second path 11C2 as flow paths. In the third portion 11C, a plurality of pin fins 11C3 are formed downward. The plurality of pin fins 11C3 are provided to enhance a cooling effect by generating a turbulent flow in the coolant in the flow path of the third portion 11C. The first path 11C1 is provided below the plurality of pin fins 11C3. The second path 11C2 is a flow path provided on sides of the plurality of pin fins 11C3 and communicating with a downstream side of the third portion 11C. That is, the second path 11C2 of the third portion 11C is formed among the plurality of pin fins 11C3. Therefore, in the second path 11C2 of the third portion 11C shown in FIG. 6, the coolant and bubbles P are movable from a right side toward the fourth portion 11D on a left side.

The switching element 70a of the converter 70 is disposed at a position corresponding to the fourth portion 11D of the first cooling plate 11, and the traveling motor M is disposed at a position corresponding to the flow path continuous with the fifth portion 11E of the first cooling plate 11.

In this manner, the cooling plates 11 and 12 are formed with the flow path R such that the coolant flows through the bulk capacitors 16 of the second conversion module Bb (power supply module), the switching element 15 of the power supply module, the smoothing capacitor 67 of the main inverter unit 65, the switching element 66a of the motor drive circuit 66 of the inverter, the switching element 70a of the converter 70, and the stator of the traveling motor M in this order.

In this manner, since the power conversion device B is cooled by the coolant flowing through the first cooling plate 11 and the second cooling plate 12, an excessive temperature increase is not caused. Similarly, since the inverter C is cooled by the coolant flowing through the first cooling plate 11, an excessive temperature increase is not caused.

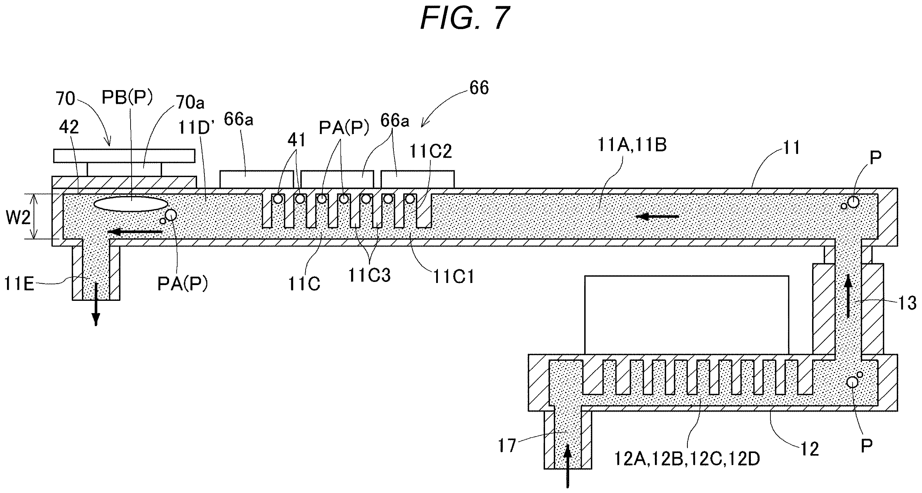

Here, for example, as shown in FIG. 7 which is a comparative example, in the first cooling plate 11, as the bubbles P, for example, bubbles PA near an upper end 41 of the second path 11C2 of the third portion 11C, large bubbles PB near an upper end 42 of a fourth portion 11D', and the like are present. In the first cooling plate 11, when the upper end 41 of the second path 11C2 of the third portion 11C is the same (has a same width W2) as the upper end 42 of the fourth portion 11D' or lower than the upper end 42, such bubbles P are likely to stay in the third portion 11C and the fourth portion 11D' and are less likely to be discharged to a downstream side. Further, since the cooling effect of the coolant is inhibited by the bubbles P staying in the third portion 11C and the fourth portion 11D', cooling efficiency for the motor drive circuit 66, the converter 70, and the like in the power conversion device B decreases.

Therefore, in the present embodiment, as shown in FIG. 6, the fourth portion 11D includes a bubble reservoir 80 that is positioned above the third portion 11C and that is capable of storing the bubbles P while causing the coolant to flow. The bubble reservoir 80 is provided at a center of a second path 11D2 of the fourth portion 11D to be described later.

Specifically, in the fourth portion 11D, a first path 11D1, the second path 11D2, and a third path 11D3 are sequentially and continuously provided so as to surround a step portion 11G erected inside the first cooling plate 11. The first path 11D1 extends upward along the step portion 11G. The second path 11D2 extends above the step portion 11G and in a horizontal direction. The third path 11D3 extends downward along the step portion 11G and is connected to the fifth portion 11E.

In the first cooling plate 11, since the fourth portion 11D is formed as described above, the upper end 41 of the second path 11C2 of the third portion 11C is configured to be lower than the upper end 42 of the fourth portion 11D. In the present embodiment, as shown in FIG. 6, the upper end 41 of the third portion 11C and the upper end 42 of the fourth portion 11D have a height difference H1. In addition, the bubble reservoir 80 has an inlet port 81 for the coolant at the upstream and an outlet port 82 for the coolant at the downstream. In FIG. 6, the inlet port 81 and the outlet port 82 are set to have a same width W1. Further, a width W3 of the first path 11D1 is substantially the same as the width W1, and a width W4 of the third path 11D3 is larger than the width W1. Although not shown, the width W1, the width W3, and the width W4 may be the same.

According to the present embodiment, when the switching element 66a (first cooling target) and the switching element 70a (second cooling target) are cooled in this order by the coolant, even if the bubbles P are mixed in the coolant, the bubbles P can stay in the bubble reservoir 80 positioned above the third portion 11C that cools the switching element 66a (first cooling target). Accordingly, for example, by disposing the switching element 66a (first cooling target) at a position other than the position facing the bubble reservoir 80, the switching element 66a (first cooling target) and the switching element 70a (second cooling target) can be reliably cooled by the coolant flowing through the first cooling plate 11. Further, since the bubble reservoir 80 can store the bubbles P while causing the coolant to flow, even if the bubbles P continue to stay in the bubble reservoir 80, the flow of the coolant is not hindered.

In the power conversion device B according to the present embodiment, the switching element 70a (second cooling target) has a heat generation amount smaller than that of the switching element 66a (first cooling target). That is, since the switching element 66a having a large heat generation amount and the switching element 70a having a small heat generation amount is sequentially cooled by the coolant flowing through the first cooling plate 11 in the power conversion device B, the switching element 66a can be effectively cooled.

### Modification of First Embodiment

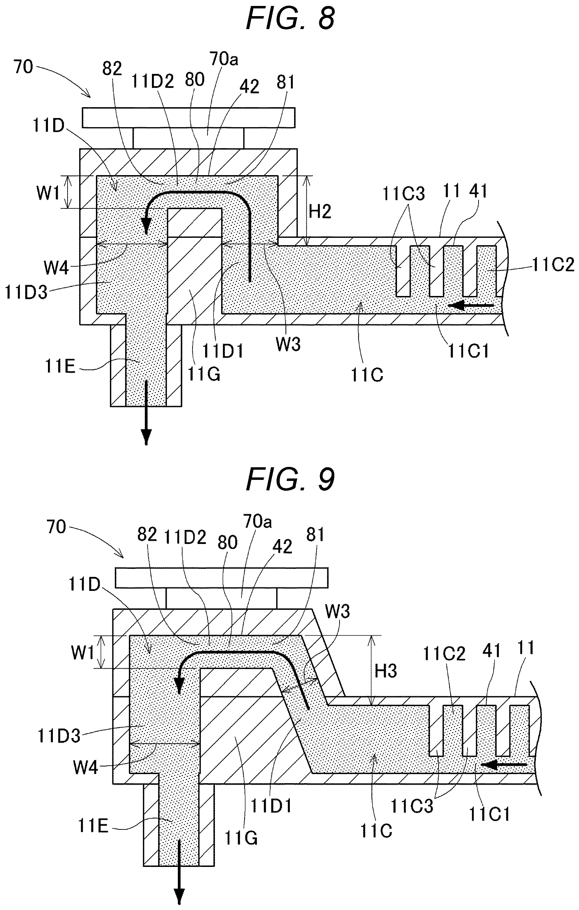

In the present modification, as shown in FIG. 8, the upper end 41 of the third portion 11C and the upper end 42 of the fourth portion 11D have a height difference H2. The width W1 of the inlet port 81 and the outlet port 82 in the bubble reservoir 80 is smaller than both the width W3 of the first path 11D1 of the fourth portion 11D and the width W4 of the third path 11D3 of the fourth portion 11D. That is, the bubble reservoir 80 (a center portion of the second path 11D2) is configured such that the widths of the inlet port 81 and the outlet port 82 for the coolant are smaller than those of the first path 11D1 and the third path 11D3 which are other portions of the fourth portion 11D. Accordingly, a flow rate of the coolant flowing through the bubble reservoir 80 increases, and the bubbles P are easily discharged through the fifth portion 11E.

### Second Embodiment

In a second embodiment, as shown in FIG. 9, the upper end 41 of the third portion 11C and the upper end 42 of the fourth portion 11D have a height difference H3. In the second embodiment, further, the first path 11D1 of the fourth portion 11D is formed to be inclined upward toward the downstream side. In other words, the step portion 11G is inclined toward the bubble reservoir 80. Other configurations are the same as those of the first embodiment.

Specifically, in the power conversion device B, the fourth portion 11D has an inclined portion (first path 11D1) that is inclined upward toward the downstream side, and the bubble reservoir 80 (a center portion of the second path 11D2) is provided at an upper end of the inclined portion (first path 11D1). When the fourth portion 11D is provided with an inclined portion inclined upward toward the downstream side as in the present embodiment, the coolant can be smoothly guided to the bubble reservoir 80.

In the second embodiment shown in FIG. 9, the width W3 of the first path 11D1 is substantially the same as the width W1, and the width W4 of the third path 11D3 is larger than the width W1. Although not shown, the width W1, the width W3, and the width W4 may be the same, or the width W1 of the inlet port 81 and the outlet port 82 in the bubble reservoir 80 may be smaller than both the width W3 of the first path 11D1 of the fourth portion 11D and the width W4 of the third path 11D3 of the fourth portion 11D as in the modification of the first embodiment.

### Other Embodiments

In addition to the above embodiments, this disclosure may be implemented as follows (those having the same functions as the embodiments are denoted by the same reference numerals as in the embodiments).
(a) In the above embodiments, the configuration in which the cooling plates 11 and 12 are stacked up to bottom is shown, but one or three or more of cooling plates may be configured to be stacked up to bottom.
(b) In the above embodiments, an example in which the cooling plate 11 is configured to be formed with the flow path R such that the coolant flows through the smoothing capacitor 67 and the motor drive circuit 66 of the main inverter unit 65, the converter 70, and the traveling motor M is shown. Alternatively, the cooling plate 11 may have the following configuration. The cooling plate 11 may be formed with the flow path R such that the coolant flows through at least the motor drive circuit 66 of the main inverter unit 65 and the converter 70. That is, the cooling plates 11 and 12 may be formed with the flow path R such that the coolant flows from the first cooling target having a relatively large heat generation amount toward the second cooling target having a relatively small heat generation amount.
(c) In the above embodiments, the coolant flow path L1 allows the coolant to circulate in the order of the first cooling plate 11 and the second cooling plate 12 of the power conversion device B, the oil cooler 32, the water-cooled condenser 31, and the radiator 34 by driving the coolant pump 33. Alternatively, the coolant flow path L1 may allow the coolant to circulate through the first cooling plate 11 and the second cooling plate 12 of the power conversion device B, the water-cooled condenser 31, the oil cooler 32, and the radiator 34 in this order by driving the coolant pump 33.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

In the embodiments described above, the following configurations are conceivable.

<1> A power conversion device (B) according to one aspect includes: a plurality of electronic components (66a, 70a); and a cooling plate (11, 12) configured to allow a coolant for cooling the plurality of electronic components (66a, 70a) to flow therein, in which the plurality of electronic components (66a, 70a) include at least a first cooling target (66a) and a second cooling target (70a), the cooling plate (11, 12) includes a first flow path (11C) formed in a horizontal direction and configured to cool the first cooling target (66a) and a second flow path (11D) disposed downstream of the first flow path (11C) and configured to cool the second cooling target (70a), and the second flow path (11D) includes a bubble reservoir (80) positioned above the first flow path (11C) and configured to store bubbles (P) while causing the coolant to flow.

According to the present embodiment, when the coolant cools the first cooling target (66a) and the second cooling target (70a) in this order, even if the bubbles (P) are mixed in the coolant, the bubbles (P) can stay in the bubble reservoir (80) positioned above the first flow path (11C) that cools the first cooling target (66a). Accordingly, for example, by disposing the first cooling target (66a) at a position other than the position facing the bubble reservoir (80), the first cooling target (66a) and the second cooling target (70a) can be reliably cooled by the coolant flowing through the cooling plate (11). In addition, since the bubble reservoir (80) can store the bubbles (P) while causing the coolant to flow, even if the bubbles (P) continue to stay in the bubble reservoir (80) due to a low flow speed of the coolant, the flow of the coolant is not hindered.

In addition, since the bubbles (P) stay in the bubble reservoir (80), it is possible to completely separate a portion where the bubbles (P) are present and a portion where the bubbles (P) are not present in the flow path (R). Therefore, the cooling targets (66a, 70a) can be effectively cooled by the coolant by disposing the cooling targets (66a, 70a) at positions where the bubbles (P) are not present in the flow path (R) provided in the cooling plate (11, 12). In addition, in the bubble reservoir (80), small bubbles (PA) are easily collected to form large bubbles (PB), and since the bubbles (P) become large, the bubbles (P) easily flow together with the coolant in the flow path (R). As a result, the bubbles (P) are easily discharged from the flow path (R). In this manner, a power conversion device (B) capable of effectively cooling the plurality of electronic components (66a, 70a) can be implemented.

<2> In the power conversion device (B) according to the above <1>, the second flow path (11D) may include a first path (11D1) extending upward from the first flow path (11C), a second path (11D2) continuous with the first path (11D1) and extending in the horizontal direction, and a third path (11D3) extending downward from the second path (11D2), and the bubble reservoir (80) may be provided in the second path (11D2).

According to the present embodiment, since the second path (11D2) in the second flow path (11D) is positioned above the first flow path (11C), the bubbles (P) can be reliably stored in the bubble reservoir (80) provided in the second path (11D2).

<3> In the power conversion device (B) according to the above <1>, the second flow path (11D) may include at least a first path (11D1) continuous with the first flow path (11C) and a second path (11D2) continuous with the first path (11D1), and the second path (11D2) may be positioned above the first flow path (11C).

According to the present embodiment, since the second path (11D2) in the second flow path (11D) is positioned above the first flow path (11C), the bubbles (P) can be reliably stored in the bubble reservoir (80) provided in the second path (11D2).

<4 > In the power conversion device (B) according to the above <1>, the second flow path (11D) may include an inclined portion (11D1) inclined upward toward downstream, and the bubble reservoir (80) may be provided at an upper end of the inclined portion (11D1).

According to the present embodiment, the bubble reservoir (80) is provided at the upper end of the inclined portion (11D1) inclined upward toward downstream in the second flow path (11D). Accordingly, the coolant mixed with the bubbles (P) smoothly flows toward the bubble reservoir (80) in the second flow path (11D), and the bubbles (P) can be efficiently separated from the coolant and can stay in the bubble reservoir (80). As a result, the first cooling target (66a) and the second cooling target (70a) can be reliably cooled by the cooling plate (11).

<5> In the power conversion device (B) according to the above <1>, the bubble reservoir (80) may be configured such that widths of an inlet port (81) and an outlet port (82) for the coolant are smaller than those of other portions (11D1, 11D3) in the second flow path (11D).

As in the present embodiment, when the widths of the inlet port (81) and the outlet port (82) for the coolant in the bubble reservoir (80) are configured to be smaller than those of the other portions (11D1, 11D3) in the second flow path (11D), flow areas of the coolant in the inlet port (81) and the outlet port (82) are reduced, and a flow rate of the coolant is increased. Accordingly, the coolant mixed with the bubbles (P) can be actively pushed away from the bubble reservoir (80). As a result, the bubbles (P) are less likely to stay in the first flow path (11C) of the cooling plate (11), and the first cooling target (66a) and the second cooling target (70a) can be reliably cooled by the cooling plate (11).

<6> In the power conversion device (B) according to any one of the above <1> to <5>, the second cooling target (70a) may have a heat generation amount smaller than that of the first cooling target (66a).

According to the present embodiment, since the first cooling target (66a) having a large heat generation amount and the second cooling target (70a) having a small heat generation amount are sequentially cooled by the coolant flowing through the cooling plate (11), the first cooling target (66a) can be effectively cooled.

### Industrial Applicability

This disclosure can be used for a power conversion device.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A power conversion device (B) comprising:
a plurality of electronic components (66a, 70a); and
a cooling plate (11, 12) configured to allow a coolant for cooling the plurality of electronic components to flow therein, wherein
the plurality of electronic components include at least a first cooling target and a second cooling target,
the cooling plate includes a first flow path (11C) formed in a horizontal direction and configured to cool the first cooling target, and a second flow path (11D) disposed downstream of the first flow path and configured to cool the second cooling target, and
the second flow path includes a bubble reservoir (80) positioned above the first flow path and configured to store a bubble while causing the coolant to flow.

2. The power conversion device according to claim 1, wherein
the second flow path includes a first path (11D1) extending upward from the first flow path, a second path (11D2) continuous with the first path and extending in the horizontal direction, and a third path (11D3) extending downward from the second path, and the bubble reservoir is provided in the second path.

3. The power conversion device according to claim 1, wherein
the second flow path includes at least a first path (11D1) continuous with the first flow path and a second path (11D2) continuous with the first path, and the second path is positioned above the first flow path.

4. The power conversion device according to any one of claims 1 to 3, wherein
the second flow path includes an inclined portion (11D1) inclined upward toward downstream, and
the bubble reservoir is provided at an upper end of the inclined portion.

5. The power conversion device according to any one of claims 1 to 4, wherein
the bubble reservoir is configured such that widths of an inlet port (81) and an outlet port (82) for the coolant are smaller than widths of other portions in the second flow path.

6. The power conversion device according to any one of claims 1 to 5, wherein
the second cooling target has a heat generation amount smaller than a heat generation amount of the first cooling target.
